# EUROPEAN PATENT APPLICATION

(11) **EP 4 535 931 A1**
(43) Date of publication of application: **09.04.2025**
(21) Application number: 23811760.0
(22) Date of filing: 19.05.2023
(51) Int. Cl.: H05K 1/09, H05K 3/46

(54) **CIRCUIT COMPONENT**

(30) Priority: 27.05.2022 JP 2022086676
(71) Applicant: Kyocera Corporation, Kyoto-shi, Kyoto 612-8501 (JP)
(72) Inventor: SANO, Hiroaki, Kyoto-shi, Kyoto 612-8501 (JP); HIGASHI, Toshifumi, Kyoto-shi, Kyoto 612-8501 (JP); IMOTO, Akira, Kyoto-shi, Kyoto 612-8501 (JP); YAMAGUCHI, Takafumi, Kyoto-shi, Kyoto 612-8501 (JP); YAMAMOTO, Sentarou, Kyoto-shi, Kyoto 612-8501 (JP)
(74) Representative: Viering, Jentschura & Partner mbB Patent- und Rechtsanwälte
(86) International application number: PCT/JP2023/018838
(87) International publication number: WO 2023/228888

(57) **Abstract**

A circuit component includes an insulation layer made of a ceramic, and an electrical conductor layer extending in an inner portion of the insulation layer in at least one of a planar direction and a direction intersecting the planar direction. The electrical conductor layer includes a metal phase and silica particles. The metal phase surrounds the silica particles.

## Description

### TECHNICAL FIELD

An embodiment of the disclosure relates to a circuit component.

### BACKGROUND OF INVENTION

A known wiring board includes an insulation layer containing a ceramic as a main component and an electrical conductor layer containing a metal as a main component. For example, such a wiring board may be obtained as follows. A metal oxide is added to a copper powder to obtain an electrical conductor material. The electrical conductor material is simultaneously fired with a glass ceramic as an insulation layer material to obtain the wiring board (refer to Patent Document 1, for example).

### CITATION LIST

### PATENT LITERATURE

Patent Document 1: JP 2003-277852 A

### SUMMARY OF INVENTION

A circuit component of the present disclosure includes an insulation layer made of a ceramic, and an electrical conductor layer extending in an inner portion of the insulation layer in at least one of a planar direction and a direction intersecting the planar direction. The electrical conductor layer includes a metal phase and silica particles. The metal phase surrounds the silica particles.

### BRIEF DESCRIPTION OF THE DRAWINGS

FIG. 1 is an enlarged cross-sectional view illustrating an example of a configuration of a wiring board according to an embodiment.
FIG. 2 is an enlarged view of a region A illustrated in FIG. 1.
FIG. 3 is a diagram illustrating an SEM observation image of an electrical conductor layer according to Sample 1.
FIG. 4 is a graph showing an EPMA spectrum of a measurement point 1 indicated in FIG. 3.
FIG. 5 is a graph showing an EPMA spectrum of a measurement point 2 indicated in FIG. 3.

### DESCRIPTION OF EMBODIMENTS

An embodiment of a circuit component disclosed in the present application will be described below with reference to the accompanying drawings. The present disclosure is not limited by the following embodiments. The embodiments can be appropriately combined within a range so as not to contradict each other in terms of processing content. In the following embodiments, the same portions are denoted by the same reference signs, and redundant explanations are omitted.

Examples of a wiring board, an electronic component, and a fuel cell will be described as the above-mentioned circuit component. Needless to say, the present disclosure can also be applied to a filter element, an inductor, a piezoelectric element, and the like, as long as an insulation layer and an electrical conductor layer are combined to obtain electrical characteristics.

A known wiring board includes an insulation layer containing a ceramic as a main component and an electrical conductor layer containing a metal as a main component. Such a wiring board is obtained by, for example, simultaneously firing an electrical conductor material, obtained by adding a metal oxide to copper powder, and a glass ceramic as an insulation layer material.

However, in the known art, there is room for further improvement in reducing the electrical resistance of the electrical conductor layer. A technique to resolve the aforementioned problem and reduce the electrical resistance of the electrical conductor layer has yet to be realized.

### Wiring Board: Electrical Conductor Layer Containing Copper

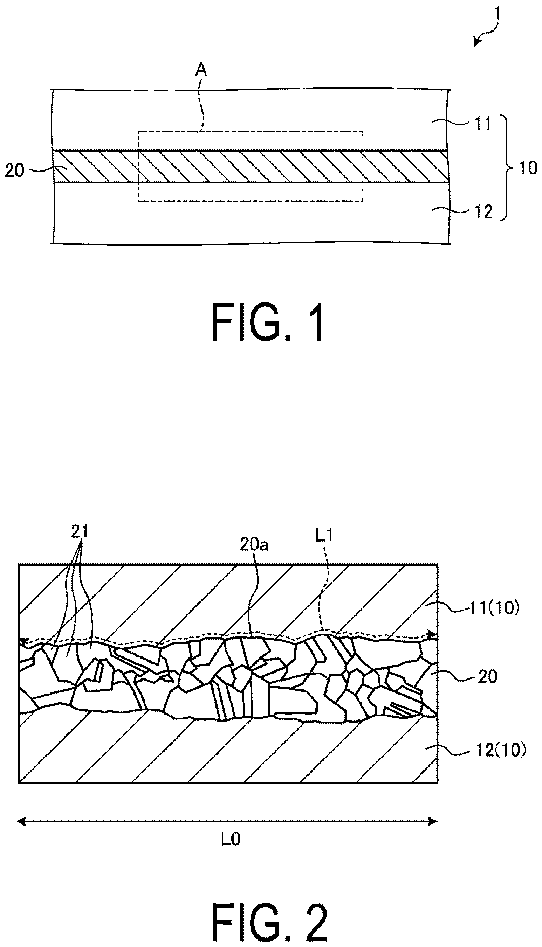

FIG. 1 is an enlarged cross-sectional view illustrating an example of a wiring board 1 according to the embodiment. FIG. 2 is an enlarged view of a region A illustrated in FIG. 1. As illustrated in FIGs. 1 and 2, the wiring board 1 according to the embodiment includes an insulation layer 10 and an electrical conductor layer 20.

Examples of the insulation layer 10 include a glass ceramic sintered body. Note that the glass ceramic sintered body may contain a ceramic such as aluminum oxide, aluminum nitride, silicon carbide, silicon nitride, or mullite as a filler.

The insulation layer 10 may be made of, for example, a glass ceramic. Thus, a green sheet that is a raw material of the insulation layer 10 and an electrically conductive paste that is a raw material of the electrical conductor layer 20 are simultaneously fired to manufacture the wiring board 1. Thus, according to the embodiment, the wiring board 1 can have reduced manufacturing cost.

The insulation layer 10 may include a first layer 11 and a second layer 12 that face each other with the electrical conductor layer 20 interposed therebetween. For example, the first layer 11 and the second layer 12 sandwich both surfaces of the electrical conductor layer 20 in a thickness direction.

The electrical conductor layer 20 has electrical conductivity and extends in a planar direction (lateral direction in FIG. 1) in an inner portion of the insulation layer 10. For example, the electrical conductor layer 20 is disposed in a predetermined pattern shape between the first layer 11 and the second layer 12. Note that, in the present disclosure, the electrical conductor layer 20 may be positioned in an exposed state on a surface of the wiring board 1.

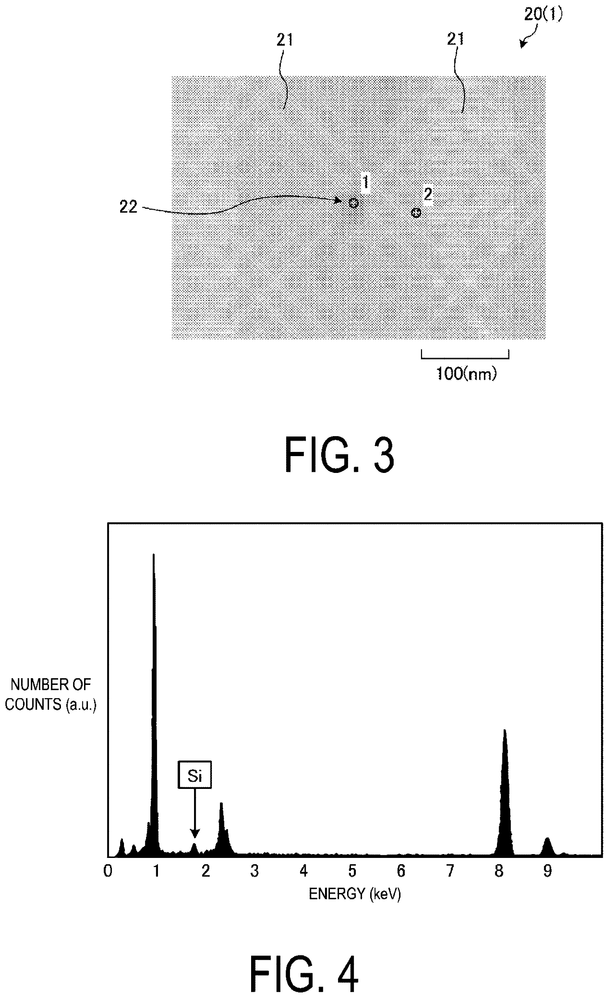

The electrical conductor layer 20 includes a metal phase and silica particles 22 (see FIG. 3). As illustrated in FIG. 2, the metal phase includes a plurality of crystallites 21. The crystallites 21 are made of a metal material such as copper, silver, palladium, gold, platinum-tungsten, molybdenum, or manganese, or an alloy material or a mixed material containing these metal materials as main components.

Here, in the embodiment, the silica particles 22 may be surrounded by the metal phase (that is, the crystallites 21). Thus, electricity easily flows through the metal phase in the electrical conductor layer 20, so that the electrical conductor layer 20 has reduced electrical resistance.

The silica particles 22 preferably have a spherical shape. In other words, the cross-sectional shape of the silica particles 22 obtained by cutting or polishing the circuit substrate and/or the electrical conductor layer 20 is preferably a circular shape.

The electrical conductor layer 20 preferably uniformly contacts the entire periphery of the silica particles 22. Here, "uniformly" means that the concentration of each main component in each region of the silica particles 22 and the electrical conductor layer 20 does not change in an analysis of the composition of the silica particles 22 and the electrical conductor layer 20 from a center portion of each of the silica particles 22 to the electrical conductor layer 20.

Each region in the silica particles 22 is a range (width) from the center portion to the outer periphery of the silica particles 22. In the electrical conductor layer 20, each region is the width of the electrical conductor layer 20 corresponding to the range (width) in the silica particles 22 described above.

Note that, when the range from the center portion to the outer periphery of each of the silica particles 22 is defined as 1, the electrical conductor layer 20 may have a width of equal to or less than 10. For example, an analyzing instrument (EPMA: Electron Probe Micro Analyzer) provided in an electron microscope is used to perform element mapping of the material of the electrical conductor layer (for example, Cu) and Si which is a component of the silica particles 22 from the electrical conductor layer 20 to the center portion of the silica particles 22. In this case, in an interface between the electrical conductor layer 20 and the silica particles 22, the counts of Cu are not recognized for the silica particles 22 or only recognized as noise, and on the contrary, the counts of Si are not recognized for the electrical conductor layer 20 or only recognized as noise.

In the embodiment, the silica particles 22 may be located at an interface between the electrical conductor layer 20 and the insulation layer 10. In other words, in the wiring board 1, silica may be present in a particulate state at a surface of the electrical conductor layer 20.

Here, the "surface of the electrical conductor layer 20" refers to a portion near an interface between the insulation layer 10 and the electrical conductor layer 20 when the electrical conductor layer 20 is formed on a surface of the insulation layer 10. The portion "near the interface" includes a range having a small width from the surface of the electrical conductor layer 20 to an inner portion of the electrical conductor layer 20. For example, the "small width" is a range within 1 (µm) from the surface of the electrical conductor layer 20.

In the embodiment, the adhesiveness between the electrical conductor layer 20 and the insulation layer 10 can be increased by providing the silica particles 22 having nano size on the surface of the electrical conductor layer 20. Note that the silica particles 22 may be present across the entire surface of the electrical conductor layer 20 facing the insulation layer 10, or may be present only in a part of the surface of the electrical conductor layer 20. When a plurality of the silica particles 22 are present at the surface of the electrical conductor layer 20, these silica particles 22 may be present in such a manner that the individual particles are isolated from each other.

The reason why the adhesiveness between the insulation layer 10 and the electrical conductor layer 20 is enhanced by providing the silica particles 22 at the surface of the electrical conductor layer 20 or near the interface between the insulation layer 10 and the electrical conductor layer 20 is considered to be that the shrinkage behavior of a metal material (for example, copper) used in the electrical conductor layer 20 during firing is similar to the shrinkage behavior of the silica particles 22.

The reason why the shrinkage behavior of the metal material used in the electrical conductor layer 20 during firing is similar to the shrinkage behavior of the silica particles 22 is considered to be that the size of the silica particles 22 is very small (nano size).

If silica particles having a size larger than on the nano scale are used, the particle size distribution based on the size is broad, and the heat capacity increases due to the size. These factors cause changes in the sintering behavior and the adhesiveness.

Note that, when glass powder of a composite oxide is used instead of the silica particles 22 having nano size, the glass powder contains a plurality of components. Therefore, a temperature range in which the glass powder is in a molten state is wider than a temperature range in which the silica particles 22 having nano size are in a molten state.

For example, the melting temperature of the glass powder may be lower than the melting temperature of the silica particles 22 having nano size. The glass powder may often have a wide particle size distribution. When the glass powder having these properties is used, aggregation and/or transfer during sintering is likely to occur in a printing pattern in which the glass powder forms the electrical conductor layer 20 during firing.

As a result, when the electrical conductor layer 20 is formed, metal particles are likely to undergo grain growth and voids are likely to be generated in the electrical conductor layer 20. This is because the glass powder easily diffuses from a portion of the printing pattern to a region forming the insulation layer 10.

On the other hand, when the silica particles 22 having nano size are used, a temperature range in which the silica particles 22 are in a molten state is narrower than a temperature range when the glass powder is used, because the silica particles 22 have a uniform composition. As a result, the electrical conductor layer 20 becomes dense, and a recessed portion having a gentle shape is easily formed in the surface along the insulation layer 10.

This is because the wiring board 1 is fired in a temperature range that is equal to or lower than the melting points of the main metal component and the silica particles 22 included in the electrical conductor layer 20 and higher than the partial melting temperature of the insulation layer 10. In this case, in particular, the firing temperature is preferably lower than the melting point (1710°C) of the silica particles 22 by 500°C or more, particularly by 700°C or more.

On the other hand, the glass powder of the composite oxide has different melting temperatures depending on the composition, or has a wide melting range from a melting start temperature to a temperature at which the glass powder completely melts. That is, the glass powder of the composite oxide may partially melt at a temperature (700°C or more and 1000°C or less) lower than the firing temperature of the wiring board 1.

When the silica particles 22 are used, the glass powder is not fired at a firing temperature lower than the melting point of the glass powder by 500°C or more. Therefore, the glass powder easily diffuses in the electrical conductor layer 20 and easily reacts with the insulation layer 10. These issues can be avoided when the glass powder of the composite oxide is used. The temperature at which the materials of the insulation layer 10 and the electrical conductor layer 20 start to melt, the melting point, and the softening point can be determined by suggestion thermal analysis, for example.

In the embodiment, the content of the silica particles 22 in the electrical conductor layer 20 may be from 0.3 to 2.5 expressed as mass ratio with the metal phase defined as 100. This can improve the adhesiveness between the electrical conductor layer 20 and the insulation layer 10.

In the embodiment, when a certain range (for example, the region A) of the electrical conductor layer 20 is specified in a cross-sectional view, L1/L0 may be in a range from 1.05 to 1.15, where L0 is a linear length in a planar direction (horizontal direction in FIG. 2), and L1 is a length of a contour 20a of the electrical conductor layer 20 (that is, a length of an interface between the electrical conductor layer 20 and the insulation layer 10).

Here, the specific range is a range in which a width of the electrical conductor layer 20 in a longitudinal direction is equal to or greater than 10 (µm) and equal to or less than 100 (µm). The width in the longitudinal direction in the specific range can be freely selected within a range from 10 (µm) or more and 100 (µm) or less. The freely selected width is determined in consideration of the thickness of the electrical conductor layer 20, the size of the crystallites 21 included in the electrical conductor layer 20, and the like.

For example, the specific range may be a range in which the electrical conductor layer 20 composed of one layer is sandwiched between two layers of the insulation layer 10 on top and bottom. A plurality of positions may be designated as the specific range in a captured image. Specifically, the surface area may be equal to or greater than 100 (µm²) and equal to or less than 10000 (µm²).

As described above, in the embodiment, an interface electrical conductivity of the electrical conductor layer 20 can be increased by making the unevenness of the contour 20a of the electrical conductor layer 20 relatively small.

The particle diameter of the silica particles 22 according to the embodiment is preferably from 1 (nm) to 50 (nm). Here, the particle diameter is a diameter. The diameter is the maximum diameter obtained in an observation of the silica particles 22.

The silica particles 22 preferably have an average particle diameter of 20 (nm). The electrical conductor layer 20 may contain the silica particles 22 having a particle diameter of 10 (nm) to 40 (nm) at a cumulative amount ratio of 70 (%) or more. In this case, the particle diameter is a diameter at a location indicating the maximum length in the silica particle in an observation of a cross section of the electrical conductor layer 20.

In the embodiment, the aspect ratio (major axis/minor axis) of the silica particles 22 may be equal to or less than 1.5. The major axis is the longest portion of each of the silica particles 22, and the minor axis is the shortest portion of the length in a direction perpendicular to the major axis.

In the embodiment, the electrical conductor layer 20 may have a fine structure constituted by the crystallites 21 that are fine copper crystallites. In this case, the plurality of crystallites 21 include crystallites each of which has a polygonal shape including a linear side, and the crystallites 21 contact each other with the sides as grain boundaries. The longest diameter of the crystallites 21 is preferably 1 (µm) or more and 10 (µm) or less. The plurality of crystallites 21 preferably include crystallites having sides of 2 or more at a percentage equal to or greater than 70 (%) in terms of the number percentage of crystallites.

In the embodiment, an area ratio of the silica particles 22 in the electrical conductor layer 20 may be from 0.006 (%) to 0.069 (%). This can enhance the interface electrical conductivity of the electrical conductor layer 20. Note that a method of determining the area ratio of the silica particles 22 in the electrical conductor layer 20 will be described later.

In the embodiment, the crystallites 21 may be made of copper as a main component, and the content ratio of copper in the electrical conductor layer 20 may be from 80 (wt%) to 99 (wt%). This can further enhance the interface electrical conductivity of the electrical conductor layer 20.

In the embodiment, as illustrated in FIG. 2, the crystallites 21 may have polygonal shapes. Accordingly, a decrease of the interface electrical conductivity in a high-frequency region (for example, from 1 (GHz) to 49 (GHz)) can be reduced, and thus, the interface electrical conductivity of the electrical conductor layer 20 in the high-frequency region can be increased.

In the embodiment, adjacent ones of the crystallites 21 are strongly bonded to each other and the arrangement of the crystallites 21 is dense. Therefore, variations in the electrical resistance can be reduced when the electrical conductor layer 20 is divided in the length direction.

Wiring Board: Electrical Conductor Layer Containing Silver The present disclosure is also applicable to a wiring board in which silver is used in the electrical conductor layer. The structure illustrated in FIG. 1 can also be applied to the wiring board. That is, the electrical conductor layer is disposed in an inner portion of the insulation layer. In this case, the material of the electrical conductor layer may be silver (Ag).

When the material of the electrical conductor layer is silver, the above-described glass ceramic sintered body is also suitable for the insulation layer. In this case, the electrical conductor layer containing silver is a sintered metal body including a plurality of crystallites. In this case, the electrical conductor layer containing silver preferably contains silica particles in a sintered metal body. That is, the electrical conductor layer is preferably a composite metal film obtained by sintering a silver powder containing silica particles.

The size of the silica particles is preferably similar to the size of the crystallites or is equal to or less than the size of the crystallites. Specifically, the silica particles preferably have an average particle diameter of 20 (nm). The electrical conductor layer may contain silica particles having a particle diameter of 10 (nm) to 40 (nm) at a cumulative amount ratio of 70 (%) or more. In this case, the particle diameter is a diameter at a location indicating the maximum length in the silica particle in an observation of a cross section of the electrical conductor layer.

Here, the size is a diameter at a location indicating the maximum length in the crystallites in an observation of a cross section of the electrical conductor layer.

When the electrical conductor layer is a composite metal film obtained by sintering a silver powder containing silica particles, the silver metal phase has a crystal structure in which the sides of a plurality of crystallites contact each other. One of the reasons for this is considered to be that the grain growth of silver is suppressed by the presence of the silica particles during firing of the silver powder containing silica particles.

The metal powder normally undergoes three dimensional grain growth. However, when the silica particles are adjacent to each other in the silver powder, the grain growth is suppressed in a direction in which the silica particles are present on the surface of a plurality of aggregates of the silver powder. In the sintered metal body made from the silver powder, the silica particles limit the direction of grain growth.

Thus, the electrical conductor layer formed by a sintered silver body obtained by sintering a silver powder containing silica particles, easily forms a crystal structure in which the sides of the plurality of crystallites contact each other.

An area ratio of the crystal structure in which the sides of the plurality of crystallites included in the electrical conductor layer contact each other is preferably 70 (%) or more per unit area. In this case, the plurality of crystallites present so as to be adjacent to each other in the electrical conductor layer preferably each have a polygonal shape.

A portion where the crystallites having the polygonal shape contact each other has sides forming a linear shape. The sides forming a linear shape are grain boundaries. The crystallites having the polygonal shape contact each other via the grain boundaries forming a linear shape.

Thus, the electrical conductor layer has a low resistance value. The interface electrical conductivity in a high frequency band increases. The void ratio in the electrical conductor layer decreases. Thus, the conductor resistance (interface electrical conductivity) of the electrical conductor layer and the coverage of the electrical conductor layer on the surface of the insulation layer can be increased.

For example, as described below, an electrical conductor layer containing silver was applied to the same insulation layer as in the case of the electrical conductor layer containing copper, to prepare a sample under the same and/or similar conditions. The electrical characteristics of the sample were measured, and an interface electrical conductivity of 80(%) was obtained. In this case, the sample was fired in an air atmosphere. The average particle diameter of the silver powder was 2 (µm). The average particle diameter of the silica particles was 20 (nm).

The electrical conductor layer of the manufactured wiring board had a crystal structure in which the sides of a plurality of crystallites contact each other. The area ratio of the crystal structure in which the sides of the plurality of crystallites included in the electrical conductor layer contact each other was about 75 (%) per unit area. In this case, most of the plurality of crystallites present so as to be adjacent to each other in the electrical conductor layer had a polygonal shape.

A portion where the crystallites having the polygonal shape contact each other had sides forming a linear shape. The sides forming a linear shape were grain boundaries. The crystallites having the polygonal shape contacted each other via the grain boundaries forming a linear shape. The area ratio of the silica particles in the electrical conductor layer was about the same as that of Sample 2 in Table 1 below.

### Electronic Component

The present disclosure is also applicable to an electronic component described below. The electronic component also includes an electrical conductor layer in an inner portion of an insulation layer. When the insulation layer includes a first layer and a second layer, the electronic component may have a configuration in which the electrical conductor layer is sandwiched between the first layer and the second layer, similarly to the wiring board 1 described above. Alternatively, the electrical conductor layer may be disposed on both surfaces of the insulation layer.

In this case, the material of the electrical conductor layer is preferably nickel. When the material of the electrical conductor layer is nickel, a ceramic material exhibiting dielectric properties is suitable as the material of the insulation layer. A ceramic material exhibiting dielectric properties may be referred to as a dielectric ceramic.

Examples of the dielectric ceramic include a ceramic material containing barium titanate as a main component. Here, the term "main component" means that barium titanate is contained in the dielectric ceramic in an amount of 80 (mol%) or more. For example, the dielectric ceramic is applied to a dielectric layer of a multilayer ceramic capacitor.

The electrical conductor layer containing nickel is a sintered metal body including a plurality of crystallites. In this case, the electrical conductor layer containing nickel preferably contains silica particles in a sintered body. That is, the electrical conductor layer is preferably a composite metal film obtained by sintering a nickel powder containing silica particles.

The size of the silica particles is preferably similar to the size of the crystallites or is equal to or less than the size of the crystallites. Here, the size is a diameter at a location indicating the maximum length in the crystallites in an observation of a cross section of the electrical conductor layer.

Specifically, the silica particles preferably have an average particle diameter of 20 (nm). The electrical conductor layer may contain silica particles having a particle diameter of 10 (nm) to 40 (nm) at a cumulative amount ratio of 70 (%) or more. In this case, the particle diameter is a diameter at a location indicating the maximum length in the silica particle in an observation of a cross section of the electrical conductor layer.

When the electrical conductor layer is a composite metal film obtained by sintering a nickel powder containing silica particles, the nickel metal phase has a crystal structure in which the sides of a plurality of crystallites contact each other. One of the reasons for this is considered to be that the grain growth of nickel is suppressed by the presence of silica particles during firing of a nickel powder containing silica particles.

The metal powder normally undergoes three dimensional grain growth. However, when silica particles are adjacent to the nickel powder, the grain growth is suppressed in a direction in which the silica particles are present on the surface of a plurality of aggregates of the nickel powder. In the sintered metal body made from the nickel powder, the silica particles limit the direction of grain growth.

Thus, the electrical conductor layer formed by a sintered nickel body obtained by sintering a nickel powder containing silica particles, easily forms a crystal structure in which the sides of the plurality of crystallites contact each other.

An area ratio of the crystal structure in which the sides of the plurality of crystallites included in the electrical conductor layer contact each other is preferably 70 (%) or more per unit area. In this case, the plurality of crystallites present so as to be adjacent to each other in the electrical conductor layer preferably each have a polygonal shape.

A portion where the crystallites having the polygonal shape contact each other has sides forming a linear shape. The sides forming a linear shape are grain boundaries. The crystallites having the polygonal shape contact each other via the grain boundaries forming a linear shape. Thus, the electrical conductor layer has a low resistance value.

In the case of a multilayer ceramic capacitor, the electrical conductor layer has a low void ratio. Thus, the conductor resistance of the electrical conductor layer and the coverage on the surface of the dielectric ceramic (also referred to as dielectric layer) can be increased. As a result, the electrostatic capacitance per unit volume of the multilayer ceramic capacitor can be increased.

For example, a capacitor is obtained by forming an electrical conductor layer containing nickel on both surfaces of a dielectric layer having a single plate shape. In such a capacitor, upon setting the electrostatic capacitance of a sample (Sample A) in which silica particles are not contained in the electrical conductor layer containing nickel to 1, the electrostatic capacitance of a sample (Sample B) in which silica particles are contained in the electrical conductor layer containing nickel is 1.1 times or more.

Specifically, the electrostatic capacitance of Sample B was 1.2 times the electrostatic capacitance of Sample A. When Samples A and B were formed, the composition of the dielectric layer included 1 (part by mole) of magnesium oxide powder, 1.5 (parts by mole) of a rare earth element (yttrium oxide), and 1 (part by mole) of manganese oxide (MnO), with respect to 100 (parts by mole) of barium titanate powder.

The electrical conductor layer was prepared by adding 1 (part by mass) of silica particles to 100 (parts by mass) of nickel powder. The average particle diameter of the nickel powder was 0.1 (µm). The average particle diameter of the silica particles was 20 (nm).

The capacitor was manufactured by printing a conductive nickel paste on both surfaces of a powder compact having a single plate shape with a diameter of 10 (mm) and a thickness of 1 (mm), as a dielectric layer, and firing the powder compact. The firing conditions included a maximum temperature of 1200 (°C) and a holding time of 2 (hours) at the maximum temperature.

An LCR meter (4274A manufactured by HP Inc.) was used to measure the electrostatic capacitance of the prepared Samples A and B. The measurement frequency was 1 (KHz) and the measurement voltage was 0.5 (V). The electrical conductor layer of the manufactured capacitor had a crystal structure in which the sides of a plurality of crystallites contact each other.

The area ratio of the crystal structure in which the sides of the plurality of crystallites included in the electrical conductor layer contact each other was about 75 (%) per unit area. In this case, most of the plurality of crystallites present so as to be adjacent to each other in the electrical conductor layer had a polygonal shape.

A portion where the crystallites having the polygonal shape contact each other had sides forming a linear shape. The sides forming a linear shape were grain boundaries. The crystallites having the polygonal shape contacted each other via the grain boundaries forming a linear shape. The area ratio of the silica particles in the electrical conductor layer was about the same as that of Sample 2 in Table 1 below.

### Fuel Cell

The present disclosure is also applicable to a fuel cell described below. The fuel cell includes a fuel electrode and a support body. The fuel electrode includes a solid electrolyte material and nickel. In the fuel cell, in particular in the material of the fuel electrode, the main component is zirconia.

In this case, the material used as the electrical conductor is preferably nickel. Also in this case, the electrical conductor containing nickel preferably contains silica particles in a sintered body. That is, the electrical conductor is preferably a composite metal obtained by sintering a nickel powder containing silica particles.

The size of the silica particles is preferably similar to or equal to or smaller than the size of the crystallites constituting the nickel electrical conductor after sintering. Here, the size is a diameter at a location indicating the maximum length in the crystallites in an observation of a cross section of the electrical conductor.

Specifically, the silica particles preferably have an average particle diameter of 20 (nm). The electrical conductor may contain silica particles having a particle diameter of 10 (nm) to 40 (nm) at a cumulative amount ratio of 70 (%) or more. In this case, the particle diameter is a diameter at a location indicating the maximum length in the silica particle in an observation of a cross section of the electrical conductor.

When the electrical conductor is a composite metal film obtained by sintering a nickel powder containing silica particles, the nickel metal phase has a crystal structure in which the sides of a plurality of crystallites contact each other. One of the reasons for this is considered to be that the grain growth of nickel is suppressed by the presence of silica particles during firing of a nickel powder containing silica particles.

The metal powder normally undergoes three dimensional grain growth. However, when silica particles are adjacent to the nickel powder, the grain growth is suppressed in a direction in which the silica particles are present on the surface of a plurality of aggregates of the nickel powder.

In the sintered metal body made from the nickel powder, the silica particles limit the direction of grain growth. The electrical conductor layer formed by a sintered nickel body obtained by sintering a nickel powder containing silica particles, easily forms a crystal structure in which the sides of the plurality of crystallites contact each other.

An area ratio of the crystal structure in which the sides of the plurality of crystallites included in the electrical conductor contact each other is preferably 70 (%) or more per unit area. In this case, the plurality of crystallites present so as to be adjacent to each other in the electrical conductor preferably have a polygonal shape.

A portion where the crystallites having the polygonal shape contact each other has sides forming a linear shape. The sides forming a linear shape are grain boundaries. The crystallites having the polygonal shape contact each other via the grain boundaries forming a linear shape. Thus, the electrical conductor has a low resistance value.

In the case of a fuel cell, the electrical conductor has a low void ratio. Thus, by using the electrical conductor, the conductor resistance can be reduced and the coverage on the surface of the sintered zirconia body can be increased. As a result, a fuel cell having a low conductor resistance can be obtained.

Regarding the conductor resistance at a temperature equal to or higher than room temperature, the electrical conductor also greatly contributes to a decrease in conductor resistance at a temperature of 1000 (°C) or lower, 700 (°C) or lower, and 500 (°C) or lower. For example, a sample having a single plate shape was prepared.

Sample C was prepared as follows. 50 (parts by mass) of zirconia (stabilized zirconia having 10 (mol%) Y) and 50 (parts by mass) of nickel powder without silica particles added thereto were mixed to prepare a powder compact. Subsequently, the powder compact was fired.

Sample D was prepared as follows. 50 (parts by mass) of zirconia (stabilized zirconia having 10 (mol%) Y) and 50 (parts by mass) of a composite metal powder in which the surface of a nickel powder was coated with silica particles were mixed to prepare a powder compact. Subsequently, the powder compact was fired.

The powder compact had a circular plate shape having a diameter of 10 (mm) and a thickness of 1 (mm). The average particle diameter of the zirconia powder was 5 (µm). The average particle diameter of the nickel powder was 3 (µm). The average particle diameter of the silica particles was 20 (nm). The amount of silica particles being added was 1 (part by mass) with respect to 100 (parts by mass) of nickel powder.

Firing was performed in an oxygen-containing atmosphere at a maximum temperature of 1300 (°C) during a holding time of 2 (hours). Afterwards, the resistance value of each prepared sample was measured. The measurement was performed after heating the Samples C and D to a temperature of 700 (°C).

A platinum wire was connected to each of Samples C and D, and the platinum wire was drawn out from the heating furnace in which Samples C and D were held. The platinum wire was connected to a terminal of a resistance measuring device disposed in an environment at room temperature.

The resistance value of the sample (Sample D) to which the silica particles were added was 0.95 times or less the resistance value (resistance value at direct current) of the sample (Sample C) to which the silica particles were not added. Specifically, the resistance value of Sample D was 0.93 times the resistance value of Sample C.

An electron microscope was used to observe the cross section of the electrical conductor layer containing nickel. The electrical conductor had a crystal structure in which a plurality of crystallites contact each other. Most of the crystallites had a polygonal shape. A portion where the crystallites having the polygonal shape contact each other had sides forming a linear shape.

The sides forming a linear shape were grain boundaries. The crystallites having the polygonal shape contacted each other via the grain boundaries forming a linear shape. The area ratio of the silica particles in the electrical conductor was about the same as that of Sample 2 in Table 1 below.

### EXAMPLES

Examples of the present disclosure will be specifically described below. Note that, in the Examples, which will be described below, a wiring board including an insulation layer made of a glass ceramic and an electrical conductor layer containing copper as a main component will be described, but the present disclosure is not limited to the following Examples.

### Sample 1

First, a mixture of 40 (wt%) of alumina particles and 60 (wt%) of borosilicate glass was prepared as a material of the insulation layer. The mixture is a glass ceramic raw material having a firing temperature of 900 (°C) to 1000 (°C).

As an organic binder, 20 (parts by mass) of isobutyl methacrylate resin and dibutyl phthalate were used per 100 (parts by mass) of the glass ceramic raw material, and a green sheet having a thickness of 100 (µm) was produced by doctor blade molding.

Copper powder having an average particle diameter of 2 (µm) (and a purity of 99.9 (wt%)) and silica particles having an average particle diameter of 20 (nm) were prepared as raw materials of the electrical conductor layer. The cumulative amount ratio of the silica particles having a diameter of 10 (nm) to 40 (nm) was 75 (%). The content of silica particles was 0.3 (parts by mass) with respect to 100 (parts by mass) of the copper powder.

As an organic binder, an isobutyl methacrylate resin and a mixed solvent of butyl carbitol acetate and dibutyl phthalate were used. A conductive paste containing copper powder and silica particles was prepared by adding 5 (parts by mass) of isobutyl methacrylate resin with respect to 100 (parts by mass) of copper powder and further adding the mixed solvent of butyl carbitol acetate and dibutyl phthalate.

The conductive paste was printed on both surfaces of the manufactured green sheet in a predetermined area and the obtained product was fired. Firing was performed in a reducing atmosphere using a mixed gas of hydrogen and nitrogen at a maximum temperature of 930 (°C) during a holding time of 2 (hours). A plurality of green sheets were layered to obtain a thickness of 500 (µm). Thus, the wiring board 1 of Sample 1 was obtained.

### Samples 2 to 5

The wiring boards 1 of Samples 2 to 5 were obtained by a method and under conditions same as, and/or similar to Sample 1 described above, except for the content of the silica particles in the process of preparing the conductive paste.

Note that in Samples 2 to 5, the content of the silica particles was respectively 1.0 (parts by mass), 2.0 (parts by mass), 2.5 (parts by mass), and 3.0 (parts by mass) with respect to 100 (parts by mass) of the copper powder in the process of preparing the conductive paste.

### Sample 6

The wiring board 1 of Sample 6 was obtained by a method and under conditions same as, and/or similar to Sample 1 described above, except for the process of preparing the conductive paste. Note that in Sample 6, copper powder (having a purity of 99.9 (wt%)) with an average particle diameter of 2 (µm) and borosilicate glass powder having an average particle diameter of 2 (µm) were prepared as raw materials of the electrical conductor layer. The content of the glass powder was 1.0 (parts by mass) with respect to 100 (parts by mass) of the copper powder.

As an organic binder, an isobutyl methacrylate resin and a mixed solvent of butyl carbitol acetate and dibutyl phthalate were used. A conductive paste containing copper powder and glass powder was prepared by adding 5 (parts by mass) of isobutyl methacrylate resin with respect to 100 (parts by mass) of copper powder and further adding a mixed solvent of butyl carbitol acetate and dibutyl phthalate.

### Samples 7 and 8

The wiring boards 1 of Samples 7 and 8 were obtained by a method and under conditions same as, and/or similar to Sample 6 described above, except for the content of the borosilicate glass powder in the process of preparing the conductive paste. Note that in Samples 7 and 8, the content of the borosilicate glass powder was respectively 3.0 (parts by mass) and 5.0 (parts by mass) with respect to 100 (parts by mass) of the copper powder in the process of preparing the conductive paste.

### Various Evaluations

The wiring board 1 of each of Samples 1 to 8 obtained as described above was cut. The cut surface was mirror polished, and the cross section was observed with a scanning electron microscope (SEM) and an electron probe microanalyser (EPMA).

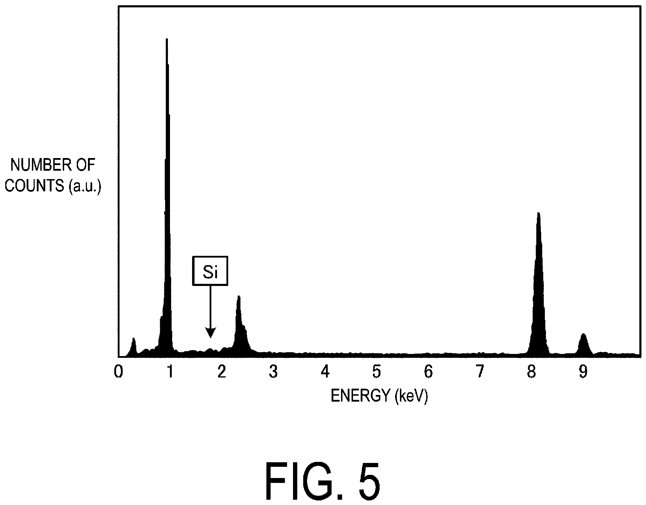

FIG. 3 is a diagram illustrating an SEM observation image of the electrical conductor layer 20 according to Sample 1. FIG. 4 is a graph showing an EPMA spectrum of a measurement point 1 indicated in FIG. 3. FIG. 5 is a graph showing an EPMA spectrum of a measurement point 2 indicated in FIG. 3.

As illustrated in FIGs. 3 to 5, in Samples 1 to 5, the silica particles 22 (corresponding to the measurement point 1 at which a Si peak was observed) were observed between copper crystallites 21 (corresponding to the measurement point 2 at which no Si peak was observed) adjacent to each other. In other words, in the observation of the embodiment, the silica particles 22 were surrounded by the metal phase (that is, the crystallites 21).

In the observation of Samples 1 to 5, the silica particles 22 were also located at the interface between the electrical conductor layer 20 and the insulation layer 10, which is not illustrated in the drawings.

By using the SEM observation images obtained as described above, the ratio L1/L0 of the length L1 of the contour 20a of the electrical conductor layer 20 to the linear length L0 in the planar direction was measured in each of Samples 1 to 8.

Specifically, first, a point A and a point B were selected on both ends of one contour 20a of the electrical conductor layer 20 captured in the cross-sectional image. A straight line was drawn between the point A and the point B, and a length of the straight line was defined as L0. A length of the contour 20a from the point A to the point B was obtained by using an image processing device, and the length was defined as L1. Finally, L1/L0 was determined as a ratio of the two lengths.

By using the SEM observation image obtained as described above, an area ratio of the silica particles 22 in each of Samples 1 to 8 was measured. Specifically, first, a plurality of square regions each of which had a length from 1/10 to 1/2 of the thickness of the electrical conductor layer 20 captured in the cross-sectional image were specified. For example, from eight to ten square regions were specified in such a manner as to be continuously aligned in the direction (planar direction) in which the electrical conductor layer 20 extends.

An area of the metal portion (corresponding to the crystallites 21) in the region delimited by the square shape was defined as A0. An area of a black portion (corresponding to the silica particles 22) illustrated in FIG. 3 was defined as A1.

The ratio A1/A0 of the two surface areas was defined as the area ratio of the silica particles 22 in one square region. Finally, the average value of the area ratio of the silica particles 22 in the plurality of square regions was defined as the area ratio of the silica particles 22 of the sample.

Note that, upon using an SEM observation image, the silica particles 22 were identified by EPMA. When the periphery of one of the silica particles 22 was blurred in the SEM observation image, the center between a position determined as the silica component and a position determined as the metal phase was set as the boundary between each of the silica particles 22 and the metal phase.

The interface electrical conductivity was measured in each of the wiring boards 1 of Samples 1 to 8 obtained as described above. The interface electrical conductivity was measured by a cylindrical dielectric resonator method, which will be described below. In the measurement, a sample having a diameter of 50 (mm) and including the electrical conductor layer 20 formed substantially entirely on both surfaces thereof was used.

In a method of measuring the interface electrical conductivity, a cylindrical dielectric resonator method is utilized to measure the electrical conductivity at an interface between a conductor and an insulation layer, that is, at a conductor interface. For this purpose, an insulation layer including a conductor formed therein is attached to both end surfaces or to one end surface of a dielectric cylinder made of a dielectric material having a known relative permittivity and dielectric loss such that a predetermined relationship is established, to form a dielectric resonator.

The principle of this measurement method is the following. Electrical conductor plates that are large enough so that an edge effect can be ignored (usually, electrical conductor plates having a diameter D of about three times a diameter d of the dielectric cylinder) are placed in parallel on both end surfaces of the dielectric cylinder having a predetermined dimensional ratio (height h/diameter d) and supported thereon to form an electromagnetic field resonator. In this case, a high-frequency current flowing through the electrical conductor plates in a TEomn resonance mode (hereinafter, referred to as the TEomn mode) is distributed only on a short-circuited surface, that is, a surface at which the dielectric body and the electrical conductor face each other.

In the dielectric resonator, the high-frequency current flowing through the electrical conductor in the TEomn mode (m = 1, 2, 3, ..., n = 1, 2, 3, ...) is distributed only at an interface between the electrical conductor and a dielectric substrate in contact with the dielectric cylinder. Thus, the interface electrical conductivity can be calculated from a resonant frequency f0 measured in the TEomn mode (m = 1, 2, 3, ..., n = 1, 2, 3, ...) and no-load Q and Qu. The interface electrical conductivity was measured at a frequency of 10 (GHz).

Each of the wiring boards 1 of Samples 1 to 8 obtained as described above was evaluated regarding conductor peeling. A sample for evaluation was obtained by layering the insulation layer 10 on each of both surfaces of the electrical conductor layer 20 of which each side was from 10 (mm) to 50 (mm).

In the evaluation of the conductor peeling, first, the sample for the evaluation was cut at a position of about 1/2 of the length in one direction, and each interface between the insulation layer 10 and the electrical conductor layer 20 in the cross section was observed. When at least one peeled portion was observed, "presence of peeling" was determined, and when no peeled portion was observed at all the interfaces, "absence of peeling" was determined.

Note that in the above-described determination, the state of "presence of peeling" was determined when a length of a region where the insulation layer 10 and the electrical conductor layer 20 were separated from each other by a distance of 0.1 (mm) or more was 1 (mm) or more.

A thermal shock resistance test was performed by a method in which each of the wiring boards 1 of Samples 1 to 8 obtained as described above was immersed in a heated solder bath for about 1 second. In the thermal shock resistance test, the temperature of the solder bath was set to two temperatures, that is, 325 (°C) (i.e., ΔT = 300 (°C)) and 355 (°C) (i.e., ΔT = 330 (°C)).

The cross section of the wiring board 1 was polished to obtain a sample for observing cracks in the wiring board 1 with a stereoscopic microscope. A sample having no cracks was evaluated as "A", a sample having a small number of cracks was evaluated as "B", and a sample having a large number of cracks was evaluated as "C".

Table 1 shows the content of copper powder, silica particles, and glass powder in the electrical conductor layer 20, a value of L1/L0 in the electrical conductor layer 20, an area ratio of the silica particles in the electrical conductor layer 20, a measurement result of the interface electrical conductivity at a frequency of 10 (GHz), an evaluation result of the occurrence of conductor peeling, and a test result of the thermal shock resistance test for each of Examples 1 to 8. Note that the measurement result of the interface electrical conductivity at a frequency of 10 (GHz) is a relative value when an interface electrical conductivity at a direct current is set to 100 (%).

### [Table 1]

**Table 1**

| | Electrical conductor layer | | | | | Interface electrical conductivity (10 GHz) (%) | Conductor peeling | Thermal Shock Resistance Test | |
|---|---|---|---|---|---|---|---|---|---|
| | Cu content (parts by mass) | Content of silica particles (parts by mass) | Glass content (parts by mass) | L1/L0 | Area ratio of silica particles (%) | | | ΔT 300°C | ΔT 330°C |
| Sample 1 | 100 | 0.3 | 0 | 1.05 | 0.006 | 91 | No | A | A |
| Sample 2 | 100 | 1.0 | 0 | 1.09 | 0.026 | 90 | No | A | A |
| Sample 3 | 100 | 2.0 | 0 | 1.15 | 0.043 | 89 | No | A | A |
| Sample 4 | 100 | 2.5 | 0 | 1.21 | 0.052 | 85 | No | A | A |
| Sample 5 | 100 | 3.0 | 0 | 1.42 | 0.069 | 80 | No | A | B |
| Sample 6 | 100 | 0 | 1.0 | 1.7 | 0 | 85 | Yes | C | C |
| Sample 7 | 100 | 0 | 3.0 | 1.9 | 0 | 77 | No | A | B |
| Sample 8 | 100 | 0 | 5.0 | 2.3 | 0 | 72 | No | A | A |

From Table 1, it can be understood that the interface electrical conductivity of the electrical conductor layer 20 can be increased to 80 (%) or more by adding the silica particles 22 having nano size to the electrical conductor layer 20 and surrounding the silica particles 22 with the metal phase. That is, it can be understood in the embodiment that the electrical resistance of the electrical conductor layer 20 can be reduced by surrounding the silica particles 22 with the metal phase.

As shown in Table 1, it can be understood that, according to Samples 1 to 5 prepared by using the conductive paste in which the content of the silica particles 22 is from 0.3 (parts by mass) to 3.0 (parts by mass) with respect to 100 (parts by mass) of the copper powder, the interface electrical conductivity of the electrical conductor layer 20 can be increased and the conductor peeling of the electrical conductor layer 20 can be reduced.

According to Samples 1 to 4 prepared by using the conductive paste in which the content of the silica particles 22 is from 0.3 (parts by mass) to 2.5 (parts by mass) with respect to 100 (parts by mass) of the copper powder, the interface electrical conductivity of the electrical conductor layer 20 can be further increased, the occurrence of conductor peeling in the electrical conductor layer 20 can be reduced, and excellent thermal shock resistance can be obtained.

In Samples 1 to 3 prepared by using a conductive paste in which the content of the silica particles 22 is from 0.3 (parts by mass) to 2.0 (parts by mass) with respect to 100 (parts by mass) of the copper powder, the interface electrical conductivity of the electrical conductor layer 20 can be even further increased.

In Samples 1 and 2 prepared by using a conductive paste in which the content of the silica particles 22 is from 0.3 (parts by mass) to 1.0 (parts by mass) with respect to 100 (parts by mass) of the copper powder, the interface electrical conductivity of the electrical conductor layer 20 can be even further increased.

As shown in Table 1, by setting the value of L1/L0 in the electrical conductor layer 20 within a range from 1.05 to 1.42, the interface electrical conductivity of the electrical conductor layer 20 can be increased and the occurrence of conductor peeling in the electrical conductor layer 20 can be reduced.

By setting the value of L1/L0 in the electrical conductor layer 20 within the range from 1.05 to 1.21, the interface electrical conductivity of the electrical conductor layer 20 can be further increased, the occurrence of conductor peeling in the electrical conductor layer 20 can be reduced, and excellent thermal shock resistance can be obtained.

The interface electrical conductivity of the electrical conductor layer 20 can be further increased by setting the value of L1/L0 in the electrical conductor layer 20 within a range from 1.05 to 1.15. The interface electrical conductivity of the electrical conductor layer 20 can be even further increased by setting the value of L1/L0 in the electrical conductor layer 20 within a range from 1.05 to 1.09.

Note that, in a wiring board (so-called printed circuit board) including an insulation layer made of a resin such as an epoxy resin and an electrical conductor layer made of copper foil, the adhesiveness between the resin (insulation layer) and the copper foil (electrical conductor layer) is low, which is not shown in Table 1. Therefore, the adhesiveness can be finally secured by enlarging the unevenness of the contour of the electrical conductor layer to generate an anchor effect.

Therefore, in the printed circuit board, the value of L1/L0 in the electrical conductor layer takes a value equal to or greater than 2. In the printed circuit board, the unevenness of the contour of the electrical conductor layer is large, which reduces the interface electrical conductivity of the electrical conductor layer.

As shown in Table 1, by setting the area ratio of the silica particles 22 in the electrical conductor layer 20 within a range from 0.006 (%) to 0.069 (%), the interface electrical conductivity of the electrical conductor layer 20 can be increased and the occurrence of conductor peeling in the electrical conductor layer 20 can be reduced.

By setting the area ratio of the silica particles 22 in the electrical conductor layer 20 within a range from 0.006 (%) to 0.052 (%), the interface electrical conductivity of the electrical conductor layer 20 can be further increased, the occurrence of conductor peeling in the electrical conductor layer 20 can be reduced, and excellent thermal shock resistance can be obtained.

By setting the area ratio of the silica particles 22 in the electrical conductor layer 20 within a range from 0.006 (%) to 0.043 (%), the interface electrical conductivity of the electrical conductor layer 20 can be further increased, and the interface electrical conductivity of the electrical conductor layer 20 can be even further increased.

The interface electrical conductivity of the electrical conductor layer 20 can be even further increased by setting the area ratio of the silica particles 22 in the electrical conductor layer 20 within a range from 0.006 (%) to 0.026 (%).

Embodiments of the present disclosure have been described above. However, the present disclosure is not limited to the embodiments described above, and various changes can be made without departing from the spirit of the present disclosure. For example, although an example in which a fine powder of silica particles is added to an electrically conductive paste that is a raw material of the electrical conductor layer 20 has been illustrated in the embodiment described above, the present disclosure is not limited to the example.

For example, a ceramic fine powder other than silica (for example, alumina fine powder) may be added to the electrically conductive paste. In this case as well, the same and/or similar effects as those in the embodiment described above can be obtained.

Additional effects and other aspects can be easily derived by a person skilled in the art. Thus, a wide range of aspects of the present disclosure is not limited to the specific details and representative embodiments indicated and described above. Accordingly, various changes are possible without departing from the spirit or scope of the general inventive concepts defined by the appended claims and their equivalents.

### REFERENCE SIGNS

1 Wiring board (example of circuit component)
10 Insulation layer
20 Electrical conductor layer
20a Contour
21 Crystallite
22 Silica particle

## Claims

1. A circuit component, comprising:
an insulation layer made of a ceramic; and
an electrical conductor layer extending in an inner portion of the insulation layer in at least one of a planar direction and a direction intersecting the planar direction, the electrical conductor layer comprising a metal phase and silica particles, and the metal phase surrounding the silica particles.

2. The circuit component according to claim 1, wherein
a content of the silica particles is from 0.3 to 2.5 in a mass ratio, with the metal phase defined as 100.

3. The circuit component according to claim 1 or 2, wherein
L1/L0 is in a range from 1.05 to 1. 15 when a certain range of the electrical conductor layer is specified in a cross-sectional view, L0 being a linear length in the planar direction, and L1 being a length of a contour of the electrical conductor layer.

4. The circuit component according to any one of claims 1 to 3, wherein
the silica particles have a diameter of 10 (nm) to 40 (nm) in a cumulative ratio of 70 (%) or more.

5. The circuit component according to any one of claims 1 to 4, wherein
the metal phase comprises a plurality of crystallites comprising any one of the group consisting of copper, silver, and nickel as a main component,
the plurality of crystallites comprise crystallites each having a polygonal shape with a side that is linear, the crystallites being in contact with each other along the side as a grain boundary.
